Europäisches Patentamt

European Patent Office

Office européen des brevets

(19)

(11) EP 1 679 740 A1

(12) **EUROPEAN PATENT APPLICATION**
published in accordance with Art. 158(3) EPC

(43) Date of publication:
    **12.07.2006 Bulletin 2006/28**

(21) Application number: **04771650.1**

(22) Date of filing: **06.08.2004**

(51) Int Cl.:
    **H01L 21/306** (1974.07)    **H01L 21/3065** (1995.01)

(86) International application number:
    **PCT/JP2004/011683**

(87) International publication number:
    **WO 2005/041283 (06.05.2005 Gazette 2005/18)**

(84) Designated Contracting States:
    **DE FR GB NL**

(30) Priority: **27.10.2003 JP 2003365867**

(71) Applicant: **Sumitomo Electric Industries, Ltd.**
    **Osaka-shi,**
    **Osaka 541-0041 (JP)**

(72) Inventors:
    • **NAKAYAMA, Masahiro,**
      **c/o Itami Works**
      **Itami-shi,**
      **Hyogo 664-0016 (JP)**

    • **MATSUMOTO, Naoki,**
      **c/o Itami Works**
      **Itami-shi,**
      **Hyogo 664-0016 (JP)**

(74) Representative: **Grünecker, Kinkeldey,**
    **Stockmair & Schwanhäusser**
    **Anwaltssozietät**
    **Maximilianstrasse 58**
    **80538 München (DE)**

(54) **GALLIUM NITRIDE SEMICONDUCTOR SUBSTRATE AND PROCESS FOR PRODUCING THE SAME**

(57)    When a nitride semiconductor monocrystalline wafer is polished, a process-transformed layer is produced. Etching is required in order to remove the process-transformed layer. Being that nitride semiconductor materials are chemically inert, however, suitable etching does not exist. Although potassium hydroxide, for example, or sulfuric acid have been proposed as GaN etchants, their corrosively remove material from the Ga face is weak.

Dry etching utilizing a halogen plasma is carried out in order to remove the process-transformed layer. The Ga face can be etched off with the halogen plasma. Nevertheless, owing to the dry etching, a problem arises again—surface contamination due to metal particles. To address the problem, wet etching with, as the etchant, solutions such as $HF + H_2O_2$, $H_2SO_4 + H_2O_2$, $HCl + H_2O_2$, or $HNO_3$, which have no selectivity, have etching ability, and have an oxidation-reduction potential of 1.2 V or more, is performed.

FIGURE

**Description**

Technical Field

The present invention relates to gallium nitride (GaN) semiconductor substrates, as well as to methods of etching epitaxial substrates—GaN substrates onto which GaN, InGaN, and AlGaN films have been epitaxially grown—and to GaN substrates etched by such methods.

Background Art

In blue light-emitting device technology, blue LED devices are typically produced by epitaxially growing films including *n*-type and *p*-type GaN and InGaN layers onto a sapphire substrate to form a *p-n* junction, etching the films down to the *n*-type GaN layer, providing an *n*-electrode on the *n*-type GaN and a *p*-electrode on the p region to render unit light-emitting diodes that are cut into individual chips with a dicing saw to make LED chips, attaching stems to the chips, connecting the *p*-electrode and *n*-electrode with wires to leads, and covering the assemblies with a cap. This process has a proven performance record and is widely employed.

With sapphire substrates, manufacturing methods have been well-established; at low cost and without instability in supplies, the substrates have a proven performance record. Nevertheless, since sapphire has no cleavages, it cannot be separated into chips that follow on natural cleavages, but instead must be sliced mechanically with a dicing saw. Because sapphire is a hard, durable material, yields from the dicing oration are unfavorable. Because sapphire is an insulator, having to provide an electrode on the bottom of the substrate is unavoidable—an *n*·electrode must be provided atop the GaN film, and wire bonding is required twice. Moreover, the extra surface area needed for the *n*-electrode is a problem in that it imposes a limit on downscaling.

Against this backdrop, GaN single-crystal is promising as a substrate for InGaN-based blue light-emitting devices. Given that heating GaN does not liquefy it, and thus GaN crystal cannot be grown from the liquid phase, vapor-phase methods employed in producing GaN films are used. Available methods include HVPE, MOCVD and MOC, which are techniques in which vapor-phase precursors are supplied to form GaN or other nitride-based films onto a starting substrate.

Vapor-phase techniques have been adapted and improved upon to form thick, low dislocation GaN layers, wherein by removing the starting substrate, stand-alone GaN films are produced. Since using sapphire for the starting substrate entails the difficulty of removing the sapphire, the present applicants utilize a (111) GaAs substrate. A GaAs starting substrate may be etched off with aqua regia.

While GaN single crystal can in this way be obtained, polishing, etching, and related technology for rendering the crystal into wafers with a mirrorlike finish has not been developed. Consequently, the present stage is one in which films are grown onto the crystal as it is, without polishing or etching. In terms of GaN wafers, what can be formed onto a foreign substrate by vapor-phase growth is only *c*-plane crystal, in which the *c*-plane ((0001) plane) appears in the surface.

As far as *c*·planes are concerned, there are two, the (0001) plane and the (001) plane. These are the face in which Ga is exposed, and the face in which N is exposed. The phy'siochemical properties of these two faces are entirely different. The Ga face, being inert chemically, hardly undergoes any effects from chemicals, and, being extremely durable physically, is difficult to polish using abrasives. The N face is weaker physically and can be polished, and chemicals with which the crystal face may be etched exist.

The etching of GaN is a challenging matter that cannot be done simply. Various techniques have been devised: attaching electrodes to and etching the crystal while passing current through it, and etching the crystal while bombarding it with ultraviolet rays. Even so, the face on which etching is regarded as being possible is usually the N face, whereas etching and polishing the Ga face is difficult.

Nevertheless, to produce wafers with a mirrorlike finish, polishing is indispensable. Although the polishing process is in and of itself difficult, in situations in which the polishing of GaN wafers is somehow managed, on account of the polishing, a process-transformed layer will appear on the wafers. This is a wafer portion in which polishing abrasive and platen components invade the wafer surface and foreign matter enters the surface, compromising the crystalline structure.

Once having set in, a process-transformed layer must by all means be eliminated, and for that purpose etching must be performed. As yet, however, there is no GaN etching technology. For the most part, GaN cannot be etched with chemically active substances. Process-transformed layers are of considerable thickness; therefore, process-transformed layers cannot be removed by wet etching.

L. H. Peng et al., in "Deep ultraviolet enhanced wet chemical etching of gallium nitride," *Applied Physics Letters,* Volume 72, Issue 8 (1998), report having performed photoenhanced etching on GaN crystal by providing a platinum electrode on the crystal and soaking it in a $H_3PO_4$ solution or a KOH solution, exposing the sample to illumination from a mercury lamp that outputs ultraviolet light of 254 nm wavelength, and applying a voltage to the sample. This means that what is termed a photoelectrochemical etching technique is possible; but since their results have not been retested, there is some doubt as to whether GaN actually can be wet-etched by that technique.

Even setting such questions aside, with this technique an electrode must be formed on the GaN crystal, and after etching is finished, the metal electrode must be removed. Incomplete removal runs the risk that the GaN crystal will be contaminated by the metal. Thus, in addition to the labor involved, there is a problem with quality in that contamination is a possibility. Since the technique entails electrode formation/removal, manufacturing-wise it is ill-suited to mass-production.

D. A. Stocker et al., in "Crystallographic wet chemical etching of GaN," *Applied Physics Letters,* Volume 73, Issue 18 (1998), report etching a GaN crystal substrate by soaking it in a $H_3PO_4$ or KOH solution in which ethylene glycol is the solvent, and heating the sample to 90˚C-180˚C. The etching is strongly dependent on the crystallographic orientation. The authors note that in the (0001) plane the crystal is for the most part not etched, while the $\{10\bar{1}3\}$, $\{10\bar{1}\bar{2}\}$, $\{10\bar{1}0\}$, and $\{10\bar{1}\bar{1}\}$ families are readily etched. Because the surfaces of GaN crystal obtained by vapor-phase growth techniques are (0001), they are not etched; yet since the crystal *is* etched where there is any unevenness, the faces instead become roughened, such that smooth flat surfaces cannot be obtained. Although no distinction is made in this article, the face that for the most part is not etched would be the Ga face, not the N face.

J. A. Bardwell et al., in "Ultraviolet photoenhanced wet etching of GaN in $K_2S_2O_8$ solution," *Journal of Applied Physics,* Volume 89, Issue 7 (2001), propose—differently from the above-cited article by L. H. Peng et al.—the wet etching of GaN crystal surfaces without forming an electrode on the GaN crystal, by adding $K_2S_2O_8$ as an oxidizing agent to KOH and exposing the sample to ultraviolet rays. Sulfate radicals and hydroxyl radicals are generated by the ultraviolet illumination, and these radicals act as potent oxidizing agents, whereby gallium oxide $Ga_2O_3$ forms. The authors put forward the mechanism by which the gallium oxide $Ga_2O_3$ is subsequently dissolved by the KOH. Nevertheless, the fact that ultraviolet rays from a low-voltage mercury lamp are employed makes Teflon® (polytetrafluoroethylene) or SUS-grade steel, which can withstand UV rays, imperative in the structural components of the washing equipment. The consequent drawback is that costs are raised. In particular, the UV rays that the mercury lamp emits generate elemental radicals that constitute substances, corroding metals, insulators, and plastics, and making them worn down. Ordinary washing equipment thus cannot be employed, which means that the technique is not oriented to mass production.

Japanese Unexamined Pat. App. Pub. No. 2001-322899 proposes technology for manufacturing scratch-free, unmarred gallium-nitride based semiconductor substrates of superior surface planarity by polishing, dry-etching, and wet-washing the wafers. The publication mentions nothing, however, regarding metal contamination of the substrate surface. This is because the aim there is planarizing the substrate; in that the objective is not reduction of substrate surface contamination, the goal differs from that of the present invention.

In Japanese Unexamined Pat. App. Pub. No. 2002-43270, since washing with organic solvents leads to hydrocarbons clinging to the substrate surface, the organic solvent is held at a temperature lower than its boiling point. Hydrocarbons clinging to the surface are cleared away by running the substrate through an alkali wash or acid wash, or subjecting it to UV ozone cleaning. This only contemplates the removal of hydrocarbons, whereas with the present invention, in that contamination due to metal is taken as the problem, the object is to remove metal from the substrate surface.

Japanese Unexamined Pat. App. Pub. No. 2003-249426 proposes a method in which an SiC substrate is polished and planarized, and by sputtering the substrate with a gas cluster ion beam, surface impurities are brought down to not more than $10^{11}cm^{-2}$ (atoms/$cm^2$). Nevertheless, in the specification there is no mention as to category of elements in the residual impurities, nor is any mention made of a way to evaluate the impurity concentration.

Disclosure of Invention

Freestanding GaN crystal substrates have become manufacturable by vapor-phase growth, but polishing, etching, and like surface-processing technology to render the substrates into wafers with a mirrorlike finish for device fabrication has yet to be established.

In the present invention, provision is made for setting up a halogen plasma to dry etch GaN in order to remove the process-transformed layer resulting from polishing the crystal. A method of superficially removing GaN by drying etching has been newly discovered by the present inventors. The method is one of reactive ion etching (RIE) using a chlorine plasma. This process will be detailed later.

It was found that the process-transformed layer resulting from polishing could be removed by dry etching. At the same time, however, it was found that owing to the dry etching, metal microparticles and microparticles of metal oxides, silicides, or similar metal compounds cling to the substrate surface, becoming a fresh source of contamination.

The microparticles will be described later, but are metals including Si, Mn Fe, Cr and Ni, and as such cannot be removed by dry etching.

On that account, in the present invention it was determined to carrying out chemical-based wet etching following the dry etching. The goal of doing so is not, as with ordinary etching, removal of the process-transformed layer, but removal of metal residues produced afresh by the dry etching process. Although it was noted before that hardly any chemicals capable of etching the surface of GaN are available, because in this case etching of the GaN itself is not necessary, and instead the objective is to take away metal clinging to the surface, that alone is sufficient.

Nevertheless, there is another problem—not just the metal residues resulting from the dry etching.

The other problem is that the GaN manufactured by the present applicants does not possess a uniform Ga face and a uniform N face. The present applicants have adopted a method (which they have provisionally termed the "stripe growth method") of growing crystal GaN by means of a technique in which in order to reduce the dislocation density, defect-gathering areas in stripe form are deliberately created within the crystal, causing defects to collect there. The applicants have come to understand that these defect-gathering stripe areas are monocrystalline regions in which the GaN crystal axis is reversed. This means that a complex crystal is produced in which the crystal axis in the stripe regions is upended, and the crystal axis in the non-stripe region is upright. Consequently, the GaN manufactured by the present applicants is not, strictly speaking, monocrystalline.

Excepting the stripe regions, however, the GaN is monocrystalline, and because the stripe regions do not have to be used, they are not prohibitive of device fabrication. While that may be the case, the GaN made by the present applicants is such that the non-stripe face is the Ga face and the stripe face is the N face, and is complicated by being formed with the Ga face alternating with the N face.

The Ga face and the N face differ in polishing, and the Ga face and the N face differ in etching. Even in terms of performing wet etching, using a chemical such that the etching speeds in the Ga face and in the N face differ considerably will lead to pitted surfaces. In other words, this means that chemicals having selectivity in etching must not be used.

For polishing, the free-abrasive method is available, in which the wafer is sandwiched between upper and lower platens, and while a polishing slurry containing a loose abrasive is dispensed in between them, the upper and lower platens are spun in opposite directions to grind the wafer. While available abrasives include diamond, SiC, and silica, given GaN's high degree of hardness, diamond abrasive is employed. Even with diamond abrasive, grinding cannot be done quite that simply. Given that the coarser is the size of the abrasive, the faster is the polishing speed, polishing is done a number of times, with the abrasive size being decreased little by little.

For example, using a platen that is a round cast-iron plate over which a polishing cloth is stretched is a typical way to polish, but with GaN, a loose abrasive process is not used, since scratches would otherwise be introduced into the surface, and instead a fixed abrasive process is utilized. A fixed abrasive process is one in which an abrasive such as diamond is embedded so as to be at a constant height into a substrate of metal or other suitable material. Making the height of the abrasive constant is in order to realize a uniform polishing speed so that scratches or other surface flaws will not be introduced. Specifically, it is advisable to polish the GaN substrate utilizing a platen in which diamond abrasive is embedded into a copper (Cu) base disk.

In vapor-phase produced, as grown GaN crystal, with the surface being rough there will also be bowing. By means of polishing devised with the elimination of bowing as one of the objectives, bowing can be mitigated. Inasmuch as polishing to eliminate bowing is not an object of the present invention, such polishing will not be detailed here. Other than copper, the platen baseplate can also be of a material such as iron or Sn—what is required is that the material be soft for embedding the abrasive.

Polishing itself is not the object of the present invention. Although smooth flat surfaces can be obtained by a polishing process, the downside is the problem of a process-transformed layer being generated anew. No matter what the type of wafer, even with Si wafers or GaAs wafers, the generation of a process-transformed layer is a problem. Nonetheless, clearing away the process-transformed layer by wet etching eliminates the problem.

In the case of GaN, however, wet etching is not possible. Although chemicals that can corrosively remove material from the N face are available, chemicals effective for the corrosive removal of material from the Ga face are not. Nevertheless, in not eliminating the process-transformed layer practicable GaN wafers will not result, nor will their utilization in device formation be possible. Somehow a means of clearing away the process-transformed layer has to be pursued.

A first object of the present invention is to afford smooth, flat GaN wafers in which the process-transformed layer resulting from polishing has been removed to enable devices to be fashioned onto the wafers.

If metal remains behind on the surface of a GaN wafer, contaminating the surface with metal atoms, epitaxial crystal growth when devices are fabricated will be incomplete, which leads to a likelihood that faults such as current leakage and incompleteness/dark current in the *p-n* junctions will be brought about, degrading the light-emitting efficiency of the fabricated devices. Taking these considerations into account, a second object of the present invention is to afford GaN wafers possessing favorable surfaces as being practically free of superficially clinging metal residues.

A third object of the present invention is to afford a complex wafer in which the Ga face and the N face are exposed in alternation, yet rendered so that roughness due to the difference in crystallographic orientation will not appear.

A fourth object of the present invention is to make available an etching method for effectively removing the process-transformed layer resulting from polishing.

A fifth object of the present invention is to make available a wet etching method rendered so as not to produce roughness due to the crystallographic orientation even with GaN wafers possessing complex surfaces in which the Ga face and N face alternate with each other.

A sixth object of the present invention is to make available a method of evaluating the type and quantity of metal that remains behind on the surface of a GaN substrate.

Brief Description of Drawing

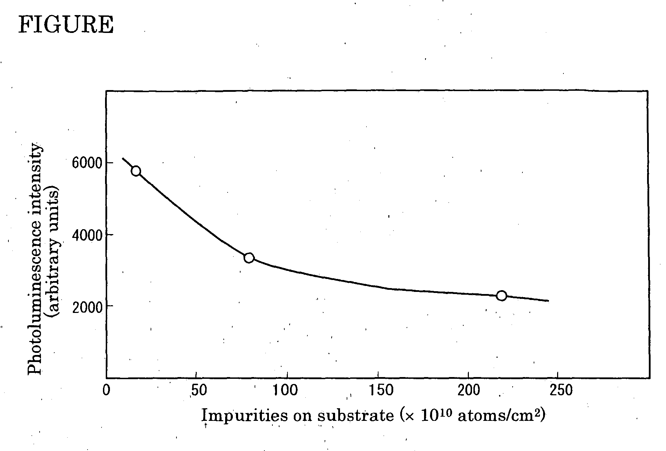

The figure is graph plotting the results of measuring residual metal atom density (x $10^{10}$ atoms/cm$^2$) on a GaN substrate surface, and the photoluminescence produced by growing epitaxially onto the substrate a GaN layer of 2 $\mu$m thickness and an InGaN layer of 0.2 $\mu$m thickness, and bombarding the substrate with a 325 nm laser beam from a HeCd laser. The horizontal axis is the metal atom density, and the vertical axis is the photoluminescence intensity (arbitrary scale graduations). The photoluminescence desirably is of 2.0 scale graduations or more, which corresponds to a metal atom density of $100 \times 10^{10}$ atoms/cm$^2$.

Best Mode for Carrying Out the Invention

The present invention dry-etches the surface of GaN using a halogen plasma, and wet etches the surface using an aqueous solution of hydrogen fluoride + hydrogen peroxide, sulfuric acid + hydrogen peroxide, hydrogen chloride + hydrogen peroxide, nitric acid, hydrogen chloride + ozone, etc., to manufacture mirrorlike-finish GaN wafers with minimal metal contamination and possessing smooth, flat surfaces. Thus, in present invention the process-transformed layer generated by the polishing is removed by dry etching, and the clinging metal contamination due to the dry etch is removed by wet etching.

In order to remove nonmetal microscopic debris, alkali is used, while to rid the wafers of organic matter, an organic solvent is used. This is the same as is the case with Si wafers, for example.

The present inventors discovered that although the Ga face of GaN essentially cannot be corrosively etched with chemically active substances, surface material can effectively be etched away from the crystal by reactive ion etching (RIE) using a halogen plasma.

A halogen gas such as chlorine, fluorine, bromine, hydrogen chloride, or hydrogen fluoride, or else a hydrogen halogenide gas, is introduced into an RIE chamber, a vacuum ($10^{-3}$ to 10 Pa) is drawn on the chamber, and a halogen plasma is generated by applying ac power (100 W to 1 kW) between electrodes, or else by introducing microwave energy (200 W to 2 kW) into the chamber. It was found that the plasma produced is a gaseous substance rich in reactivity and containing halogen ions and halogen radicals, and is equally capable of etching the N face and the Ga face.

In the embodiment examples, RIE utilizing chlorine gas is employed, but the superficial etching of GaN substrates is also possible with other halogens, or a hydrogen halogenide gas. With a process-transformed layer at times amounting to considerable thickness, it cannot be removed by wet etching, but by means of dry etching, a process-transformed layer of considerable thickness can be removed.

Although the process-transformed layer problem was resolvable, dry etching strews abundantly reactive plasma throughout the chamber, and because the substrate corrodes, what then becomes a problem is substrate-surface contamination due to fresh metal. Since chambers that withstand plasma are made of stainless steel, the chamber wall surfaces are etched by plasma that contains metals such as Fe, Ni, Cr, or Al, and particles of the chamber constituents are incorporated into the gas, landing on and clinging to the substrate.

Furthermore, susceptors, which retain the substrates in the dry etch operation, are superficially attacked by the plasma, as a consequence of which metals that constitute the susceptor can cling to the surface of the substrate. Such atomic elements give rise to a problem of fresh metal contamination.

If metal is left thus clinging to the substrate, even if it has a mirrorlike finish, the lattice structure of epi-grown GaN or InGaN films atop the surface will be compromised, spoiling the crystallinity. Consequently, if photoreceptors were manufactured, problems such as dark current increasing and degrading the light-emitting efficiency, and if lasers were, the lasing threshold current fluctuating, would be occasioned. In order to avert such problems, residual metal on the substrate surface must be reduced, but doing so by dry etching is impossible—wet etching must be employed.

It is also necessary to eliminate, other than such metals, smudges from organic substances. In addition, it can also happen that $SiO_2$, which originates in polishing agents and associated chemical substances, clings to the substrate surface; therefore, the substrate also must be rid of silicon oxide.

To take off organic-substance based smudges, the wafer is put into an organic solvent and sonicated. An agent such as isopropyl alcohol, for example, is utilized as the organic solvent.

Hydrogen fluoride (HF) is suited to taking off silicon oxide ($SiO_2$), as is well known. The problem is metals (Fe, Cr, Ni, Mn, ...) apart from metalloid silicon. Inasmuch as metals cling to the surface, if the surface itself can be removed at a certain thickness, then these metals can also be removed.

As has been repeatedly stated, a chemical such as can independently and effectively eat away at the Ga face of GaN has yet to be found. Nevertheless, the difficulty of removing metal that is only clinging to the Ga face and N face of GaN is different from the difficulty of removing a portion of the GaN itself. Metal would cling to the surface in the form of the metal alone, or as an oxide or silicide, and as such removing the metal with extant chemicals is possible. Metals in these forms should either be rinsed away at the particle level, or the metal should be dissolved and rinsed away.

Inasmuch as contaminants are removed, this can be called "washing." Nevertheless, as will be described later, since the wash uses powerful acids or bases, terming it "wet etching" would, after all, seem more appropriate. Thus, hereinafter the process following on dry etching will be termed wet etching, and each of the operational steps making up this process shall be called a wash.

Herein lies another problem. The *c*-plane GaN wafers that the present inventors manufacture is not monocrystalline in the ordinary sense. A coating, of $SiO_2$ for example, that serves as defect-forming seeds is formed in a stripe configuration (or dot—i.e., island—configuration) onto a starting substrate, then the GaN crystal growth is carried out. Defect-gathering areas are created on the seeds, and dislocations come together apace, amassing inside the confined defect-gathering areas. Thanks to this process, the portions outside the defect-gathering areas turn out to be high-quality crystal of low dislocation density.

Initially the present inventors were uncertain as to what the nature of the crystalline structure of the defect-gathering areas is, but at present understand that the defect-gathering areas seem to be single crystal in which the crystal axis is reversed. Therefore, when *c*-plane crystal is grown by the present applicants' technique, the major portion of the surface is a (0001) Ga face, but the defect-gathering areas in the center of the portions where the seeds were are (000$\bar{1}$) N faces. In other words, the product is not a single crystal, but crystal in which Ga and N faces are intermixed.

Since this is to be wet etched, using a chemical whereby there would be a great discrepancy between the rates at which the Ga and N faces are etched is undesirable, because the surface would instead end up becoming pitted. The characteristic such that the etching rates on the GaN and N faces are different is called selectivity, as has been noted. Because the goal of the wet etching is not to etch the GaN crystalline surface, but to dissolve/remove surface-residual metal, it is not a drawback if the chemical is lacking in ability to corrode the Ga face. Rather, it is better that the G-face etching speed $S_{Ga}$ and the N-face etching speed $S_N$ be as close as possible. Ideally they would be

$$S_{Ga} = S_N \qquad\qquad\qquad (1).$$

This means that there is no selectivity; and it would not be a problem if both sides are 0. Indeed, it would therefore be better to say that what is desired is that the N face not be corroded. This is just the opposite of what has been desired for the properties of GaN wet-etching materials up till now.

As a property of wet etching to date, a crucial requisite has been that the process strongly corrodes a portion, anyhow, of the GaN, wherein chemicals that have a strong ability to etch the N face have been found and these have been recommended as an etchant for use on GaN. Nevertheless, these having largely been strongly selective etchants, they are not what is required in the present invention. Having selectivity means

$$S_{Ga} \neq S_N \qquad\qquad\qquad (2),$$

and this difference being large means that the etchant is strongly selective. To find out what sorts of chemical solutions are suitable, various acids and bases were investigated as to pH, selectivity, GaN etching ability, and malodorousness. Here "pH" limits the range of concentration of the chemical solutions that were tested, and is not a property of the chemical solutions themselves. This limit may be given as molar concentration, and since molar concentration and pH are uniquely correlated for every chemical, herein they are lent a commonality to make it so that concentration is represented by pH.

Since what is indicated here are a chemical's properties at a given pH, acids whose pH is more on the acidic side, or bases whose pH is more on the basic side, than the chemical's have an etching ability that is higher than the chemical's, meaning that they are substances that are likewise suitable. As to "selectivity," in cases in which there is no foregoing difference in the speeds at which the chemical corrosively removes material from the Ga face and from the N face, there is said to be no selectivity, and in cases in which the speed at which the chemical corrosively removes material from the N face is pronouncedly faster than from the Ga face, the selectivity is said to be high (there are no instances of the reverse).

Etching ability on the Ga face and the N face differs. However, since the extent to which they differ is expressed as selectivity, " etching ability" herein means etching ability on the Ga face. As to malodorousness, although it is unrelated to etching action, strongly foul odor would be detrimental to the working environment. Since wafers are to be mass produced, the production work is desirably carried out using a chemical that to the extent possible is not malodorous. Thus, malodorousness is a serious factor.

Table I pH, selectivity, etching ability, and malodorousness of chemical solutions

| Chemical solution | pH | Selectivity | Etching ability | Malodorousness |
|---|---|---|---|---|
| KOH | 10 to 12 | Strong | None | None |
| $NH_4OH$ | 10 to 12 | Weak | Weak | Strong |
| $H_2O_2$ | 3 to 4 | None | Weak | None |
| $H_3PO_4$ | 1 | Strong | Strong | None |
| HF | 1 to 3 | None | Weak | None |
| $HNO_3$ | 1 | None | Strong | None |
| $H_2SO_4$ | 1 | None | Strong | None |
| HCl | 1 | None | Strong | Strong |

Since potassium hydroxide (KOH) is strongly selective, it is unsuitable as an etchant for wet etching in the present invention. Although it is corrosive on the N face, it is not corrosive on the Ga face. While ammonium hydroxide ($NH_4OH$) is weakly selective, the solution cannot corrosively remove material from Ga and is strongly malodorous; therefore it is unsuitable. Hydrogen peroxide ($H_2O_2$) has a weakly acidic action, but has oxidizing power. It has no selectivity, is weakly corrosive, and is not malodorous; therefore, apart from the etching ability condition, hydrogen peroxide satisfies the etchant conditions according to the present invention. Accordingly, this means that if used together with another chemical substance that is corrosive, hydrogen peroxide has the potential to be a suitable etchant.

Phosphoric acid ($H_3PO_4$) has been introduced, in the literature noted earlier, as a novelly discovered etchant for GaN, but because phosphoric acid is strongly selective it is unsuitable as an etchant in the present invention. Hydrogen fluoride (HF) is not selective, is weakly corrosive, and is not malodorous; therefore, if combined with another substance that is corrosive, hydrogen fluoride could be an etchant that the present invention requires.

Nitric acid ($HNO_3$) has no selectivity, is strongly corrosive, and is not malodorous, and thus possesses the qualifications for an etchant under the present invention. Tested herein was pH = 1, high-concentration $HNO_3$, which means that the acid may be used at a $pH \leq 1$ concentration higher than that. Sulfuric acid ($H_2SO_4$) has no selectivity, is strongly corrosive, and is not malodorous, and thus possesses the qualifications for an etchant under the present invention.

Hydrochloric acid (HCl) has no selectivity but is corrosive, and thus is fine as far as those conditions are concerned, but inasmuch as the acid, giving off vapors, is malodorous, it cannot be called optimal. The acid corrodes SUS-grade steel, and thus can exert a negative influence on the equipment. But in terms of performance, HCl is a usable etchant.

Inasmuch as the goal of the wet etching is not the corrosive removal of material from GaN but to clear away clinging metals (Fe, Cr, Mn, Zn, Ni, ...) and other debris from the dry etching, more than the ability to eat away at GaN, what is desired from the etchant is a metal-ionizing action to dissolve metal into an aqueous solution. Even as a group, metals are diverse, each differing in its resistance to chemicals.

Which metals cling will not be understood ahead of time, and since many a variety of metals clings to the wafer surface, doing this or that with respect to individual metals does not make much sense. This means that what is desired is the ability to dissolve and clear away metals in general, and this should be evaluable according to the oxidation-reduction potential being high. The fact that an etchant with a high oxidation-reduction potential will of course have a considerable ability to clear away Ga by oxidizing it into $Ga_2O_3$ means that the etchant will be prominent in the power to remove Ga.

Given these considerations, the oxidation-reduction potential of various chemical solutions was measured. Since oxidation-reduction potential varies according to concentration, the concentration was additionally noted. The oxidation-reduction potentials are at the given concentrations. The results of the oxidation-reduction potential measurements are set forth in Table II.

Table II Oxidation-Reduction Potential of Chemical Solutions (Volts vs. Normal Hydrogen Electrode [NHE])

| Chemical solution | Potential (V) |
|---|---|
| dHF (0.5%) | 0.83 |
| HCl (10%) | 0.90 |
| $H_2SO_4$ (10%) | 0.92 |
| $O_3$ (10 ppm)/$H_2O$ | 1.22 |
| dHF (0.5%)/$H_2O_2$ (10%) | 1.67 |
| $H_2SO_4$/$H_2O_2$ (4 : 1) 120˚C | 1.85 |

Although dHF is often used to dissolve glass, since its oxidation-reduction potential is low, being 0.83 V, it does not take off metal particles and like debris, nor can it remove Zn or Cu. Not surprisingly, HCl and $H_2SO_4$ in 10% solutions could not really take off metal. The simple acids in these solutions lack oxidizing power. With the oxidizing power of the 10 ppm ozone ($O_3$) solution, at 1.22 V, being strong, the solution can render Ga into $Ga_2O_3$, but is unable to take off metals such as Fe, Zn and Cu. Although there is not much efficacy with hydrogen fluoride alone, dHF + $H_2O_2$, in which the dilute hydrogen fluoride is combined with hydrogen peroxide, has an oxidation-reduction potential of 1.67 V, and is able to clear away Fe, Zn, Cu and other metals. A solution in which hydrogen peroxide is mixed at 4 : 1 into sulfuric acid and heated to 120˚C also has, at 1.85 V, a strong oxidizing power.

In order to dissolve and remove metals, metal oxides, metal silicides, a 1.2 V or greater oxidation-reduction potential is necessary. Preferably, solutions with a potential of 1.5 V or greater are favorable. For those in Table II, the oxidation-reduction potentials are at the given concentrations, and increasing the concentration will also increase the potential, while decreasing the concentration will diminish the oxidation-reduction potential—that is, the potential can be adjusted according to the concentration. Therefore, oxidation-reduction potentials of at least 1.2 V or of at least 1.5 V are prescribed merely by the chemical agent and the concentration of that chemical agent.

Because hydrogen fluoride (HF), as is evident from Table I, has no selectivity but weak etching ability, the etching ability of a solution in which it is combined with hydrogen peroxide ($H_2O_2$) is reinforced. From Table II, the high oxidation-reduction potential of the dHF + $H_2O_2$ combination will also be understood. Therefore, HF + $H_2O_2$ is a promising combination.

Although sulfuric acid ($H_2SO_4$) appears, from Table I, favorable in that it is not selective and is strongly corrosive, Table II evidences that the acid's oxidation-reduction potential is low, indicating that its ability to remove metal is somewhat lacking. Combining sulfuric acid ($H_2SO_4$) with $H_2O_2$ reinforces the oxidizing power, whereby a solution efficacious in terms of selectivity, Ga etching ability, and ability to remove metal results.

Table I evidences that inasmuch as nitric acid ($HNO_3$) is not selective and is highly Ga-corrosive, the acid is a beneficial choice. The acid can be employed alone, while $HNO_3$ + $H_2O_2$, in which hydrogen peroxide ($H_2O_2$) has been added, is advantageous.

Solutions in which ozone ($O_3$) has been added to HCl, $H_2SO_4$, or $HNO_3$, which are strong acids, are also advantageous, because they have no selectivity, considerable etching ability, and high oxidation-reduction potential. Nevertheless, since ozone is by nature a gas, it does not dissolve well into an aqueous solution, and even once dissolved, it eventually is evolved from the solution; thus, a drawback to ozone is that it is difficult to handle. Accordingly, solutions advantageous as chemical agents for wet etching include:

HF + $H_2O_2$;
HCl + $H_2O_2$;
$H_2SO_4$ + $H_2O_2$;
$HNO_3$ + $H_2O_2$;
HF + $O_3$;
HCl + $O_3$;
$H_2SO_4$ + $O_3$;
$HNO_3$ + $O_3$; and
$HNO_3$.

These solutions are for taking off the metal sticking to the GaN crystal surface. For that purpose, solutions whose selectivity (for N face/Ga face) is nil, whose etching ability is strong, and whose oxidation-reduction potential is large are chosen.

Still, there is a likelihood that matter such as nonmetal, diverse debris will stick to the crystal surface. For all intents and purposes, such matter cannot be taken off with an acid. A base, then, is necessary for debris removal. The base is, for example, potassium hydroxide (KOH) or ammonium hydroxide ($NH_4OH$). Since KOH has selectivity, and because if it is used in a very active state, unevenness will appear in the Ga face and the N face, the conditions that should be chosen make the solution temperature low and the etching time short such that clinging debris comes off yet the solution does not etch the Ga face. $NH_4OH$ can also be used to take off nonmetal microparticles. This base is favorable because it is weakly selective and weakly corrosive, but since it is malodorous, means must be devised so that it does not leak out.

An organic solvent (isopropyl alcohol, for example) is used to remove organic matter, which is the same as is the case with wafers of Si or related substances.

As will be described later, it is necessary that the surface particle density be $10 \times 10^{11}$ atoms/$cm^2$ or less. Furthermore, it is more preferable that the density be $5 \times 10^{11}$ atoms/$cm^2$ or less.

In order to attain these levels, it is necessary to use a solution that, by a combination of the foregoing chemical substances, has an oxidation-reduction potential of 1.2 V or more. It is more preferable that the potential be 1.5 V.

As-grown GaN freestanding single-crystal wafers produced by vapor-phase growth have at last become possible. The present is a situation in which, without carrying out any process on the wafer face, films of GaN, InGaN, AlGaN and the like are epitaxially grown thereon by MOCVD, MBE or other epitaxial growth technique. GaN surface-processing technology including polishing, etching, lapping has yet to be perfected. The present invention relates to etching. With a process-transformed layer being freshly produced due to earlier-stage polishing, etching is necessary in order to remove the layer. The Ga face of GaN is chemically impenetrable and as a practical matter cannot be etched with chemically active substances.

Given these factors, the present invention removes the process-transformed layer on the surface of a GaN wafer by dry etching (an RIE method) employing a halogen plasma. Carrying out the dry etching leads to metal particles, metal oxides, and metal silicides clinging freshly to the wafer surface. Because the GaN manufactured by the present applicants is of a complex structure in which the N face and the Ga face are intermingled, chemicals whose etching rates on the Ga face and the N face differ (that have selectivity) are unsuitable.

Thus, a chemical substance of high oxidation-reduction potential that has no selectivity and yet that can remove metal is utilized. Utilizing such chemical substances also allows metal microparticles to be neatly removed. Doing so makes it possible to produce GaN wafers with smooth planar surfaces, with no process-transformed layer, and whose surfaces are clean.

GaN single-crystal wafers manufactured by the present invention are extremely useful as substrates for blue light-emitting devices. Blue LEDs and blue LDs in which InGaN and GaN films have been deposited onto sapphire are already on the market and are in widespread use. Sapphire substrates are low-cost, have a proven performance record, and are in stable supply. But since sapphire has no cleavages, it cannot be separated into chips based on natural cleavages. The fact that sapphire is thus sliced with a dicing saw costs time and trouble, resulting in low production yields.

In laser diode (LD) implementations, the oscillator section must be polished into smooth mirrors. If the substrates are GaN, then cleaving is possible, which facilitates separation into chips and makes it possible to fashion mirror faces for LD oscillators simply. Moreover, since the lattice constant of sapphire differs from that of InGaN and GaN, as would be expected the internal stress in on-sapphire devices is large, resulting in a high defect density. In LD implementations, since high-density current is passed through the devices, there is a likelihood that the defects will spread and compromise the devices.

GaN substrates thus have advantages over sapphire substrates. Since GaN substrates have not yet arrived to where they are being put to practical use, they are costly, but if the technology progresses and demand is stimulated, the cost should go down.

Embodiments

An object of the present invention is, in order to render GaN substrates into starting wafers for device fabrication, to eliminate the process-transformed layer resulting from polishing and make the substrate surface planar. Process-transformed layer removal and planarization are done by dry etching. On account of the dry etching, however, metal particles and like debris cling freshly to the surface, such that dry etching alone does not suffice. Thereafter, wet etching is performed in order to remove metal microparticle contamination. But even then, the wet etching must be such that metal comes off. Wet etching was carried out using various etching solutions. Five different categories of experimental examples of wet etching procedures are set forth next.

Experimental Example 1 - Wet etching is organic-solvent washing only

Dry etching and wet washing were combined to process a GaN substrate. The GaN substrate that was the processed object was 50 mm $\phi$ in diameter and 400 $\mu$m in thickness.

A. Dry etching

The etching chamber has an etchant gas introduction port and a gas discharge port, with a vacuum exhausting device can be pumped down to a vacuum, is furnished with opposing upper and lower electrodes, and is configured so that from an antenna high RF power can be introduced into the chamber interior. The GaN substrate was loaded into the etching chamber, which had been drawn down in advance to a pressure of $10^{-4}$ Pa. Chlorine ($Cl_2$) gas as an etchant gas was introduced into the etching chamber interior, and the chamber interior pressure was controlled to 0.2 Pa. High RF power was applied to the upper and lower electrodes to generate a plasma, and a process for chlorine-plasma based removal of damage on the substrate was carried out according to the conditions in Table III.

Table III Dry Etching Conditions for Experimental Example 1

| | |
|---|---|
| Antenna output power | 800 W |
| Bias output power | 500 W |
| Etchant gas | Chlorine |
| Etching pressure | 0.2 Pa |
| Etching time | 150 s |

B. Wet washing - organic wash only

*B1. Organic wash*: A quartz beaker containing isopropyl alcohol was put into a water bath heated to 50˚C, and the GaN substrate was soaked in the isopropyl alcohol and washed 5 minutes. The same 5-minute wash was repeated once more (5 min × 2). Thereafter, the GaN substrate was taken out and dried in an isopropyl alcohol vapor dryer (82˚C).

Experimental Example 2 - Wet etching is organic-solvent washing + alkali wash

Dryetching and wet washing were combined to process a GaN substrate (50 mm $\phi$, and 400 $\mu$m thickness). The wet washing included an organic-solvent based wash and an alkali based wash. That is, an alkali wash was added to Experimental Example 1; however, since the process cannot finish with an alkali wash, the organic wash was done a second time at the end.

A. Dry etching

The dry etching conditions were the same as those of Experimental Example 1 (Table III).
The GaN substrate was housed into the etching chamber, which had been drawn down in advance to a pressure of $10^{-4}$ Pa; chlorine ($Cl_2$) gas as an etchant gas was introduced into the chamber, the interior pressure of which was put to 0.2 Pa, and high RF power was applied to the upper and lower electrodes to generate a plasma and dry etch the GaN substrate surface.

B. Wet washing - organic wash and alkali wash

*B1. Organic wash:* A quartz beaker containing isopropyl alcohol was put into a water bath heated to 50˚C, and the GaN substrate was soaked in the isopropyl alcohol and washed 5 minutes. The same 5-minute wash was repeated once more (5 min × 2). Thereafter, the GaN substrate was taken out and dried in an isopropyl alcohol vapor dryer (82˚C).
*B2. Alkali wash*: The GaN crystal substrate was immersed in a KOH aqueous solution heated to 45˚C and adjusted to pH = 11 to 12, was indirectly sonicated with ultrasound waves at a frequency of 990 kHz, and, with the washing solution being passed through a recirculating filter, was washed 3 minutes. The GaN substrate was then overflow-rinsed in ultrapure water.
This ultrasound wash was a process that subjected the washing solution with ultrasound vibration to induce cavitation in the solution and dislodge surface-clinging particles, and was such that at first, waves of 1 kHz or a similarly low frequency were employed, and gradually waves of high frequency were employed. Given that finer debris is supposed to come off with higher frequency, ultrasound vibration at a high vibrational frequency of about 1 MHz was employed.

This is because minute particles predominate among the metal particles that were the target of the ultrasound wash. *B3. Organic wash:* Same as the initial organic wash. The beaker containing isopropyl alcohol was put into a 50˚C water bath, and the GaN substrate was put into the washing solution and two cycles of the 5-minute wash were carried out. Thereafter, the GaN substrate was taken out and dried at 82˚C in the isopropyl alcohol vapor dryer.

Experimental Example 3 - Wet etching is organic-solvent washing + acid wash + alkali wash

Dry etching and wet washing were combined to process a GaN substrate (50 mm $\phi$, and 400 $\mu$m thickness). The wet washing was a combination of an organic wash, an acid wash, and an alkali wash. That is, an acid (HF) wash was added to Experimental Example 2; however, since the process cannot finish with an alkali wash, the organic wash was done a second time at the end.

A. Dry etching

The dry etching conditions were the same as those of Experimental Example 1 (Table III).
The GaN substrate was housed into the etching chamber, which had been drawn down in advance to a pressure of $10^{-4}$ Pa; chlorine ($Cl_2$) gas as an etchant gas was introduced into the etching chamber interior, the interior pressure of which was put to 0.2 Pa, and high RF power was applied to the upper and lower electrodes to generate a plasma and dry etch the GaN substrate surface.

B. Wet washing - organic wash, acid wash, and alkali wash

The wet washing was a process in which an acid wash (hydrogen fluoride, HF) was added to Experimental Example 2. The conditions for the organic wash and alkali wash were the same as those of Experimental Example 2.

*B1. Organic wash:* A quartz beaker containing isopropyl alcohol was put into a water bath heated to 50˚C, and the GaN substrate was soaked in the isopropyl alcohol and washed 5 minutes. The same 5-minute wash was repeated once more (5 min × 2). Thereafter, the GaN substrate was taken out and dried in an isopropyl alcohol vapor dryer (82˚C).
*B2. Acid wash:* The GaN substrate was immersed 5 minutes in a room-temperature dHF aqueous solution of pH = 2 to 3, contained in a Teflon® (polytetrafluoroethylene) vessel. The same wash was repeated two times (5 min × 2 cycles). The substrate was then overflow-rinsed in ultrapure water.
*B3. Alkali wash*: The GaN crystal substrate was immersed in a KOH aqueous solution heated to 45˚C and adjusted to pH = 11 to 12, was indirectly sonicated with ultrasound waves at a frequency of 990 kHz, and, with the washing solution being passed through a recirculating filter, was washed 3 minutes. The GaN substrate was then overflow-rinsed in ultrapure water.
*B4. Organic wash:* Same as the initial organic wash. The beaker containing isopropyl alcohol was put into a 50˚C water bath, and the GaN substrate was put into the washing solution and two cycles of the 5-minute wash were carried out. Thereafter, the GaN substrate was taken out and dried at 82˚C in the isopropyl alcohol vapor dryer.

Experimental Example 4 - Wet etching is organic-solvent washing + acid wash + alkali wash

Dry etching and wet washing were combined to process a GaN substrate (50 mm $\phi$, and 400 $\mu$m thickness). The wet washing was a combination of an organic wash, an acid wash, and an alkali wash. The type of acid was slightly different from that of Experimental Example 3, being hydrogen fluoride (HF) to which hydrogen peroxide ($H_2O_2$) was added. Adding the $H_2O_2$ was in order to raise the acidity higher. Thereafter, the substrate was alkali-washed in an aqueous ammonium hydroxide ($NH_4OH$) solution. Since the process cannot finish with an alkali wash, the organic wash was done a second time at the end. The points of difference from Experimental Example 3 are that the acid wash solution was HF + $H_2O_2$, and that the alkali wash was not KOH, but $NH_4OH$.

A. Dry etching

The dry etching conditions were the same as those of Experimental Example 1 (Table III).
The GaN substrate was housed into the etching chamber, which had been drawn down in advance to a pressure of $10^{-4}$ Pa; chlorine ($Cl_2$) gas as an etchant gas was introduced into the etching chamber interior, the interior pressure of which was put to 0.2 Pa, and high RF power was applied to the upper and lower electrodes to generate a plasma and dry etch the GaN substrate surface.

B. Wet washing - organic wash, acid wash, and alkali wash

The wet washing was a process in which hydrogen peroxide ($H_2O_2$) was added in the acid wash of Experimental Example 3. The conditions for the organic wash were the same as those of Experimental Examples 1, 2 and 3.

*B1. Organic wash*: A quartz beaker containing isopropyl alcohol was put into a water bath heated to 50˚C, and the GaN substrate was soaked in the isopropyl alcohol and washed 5 minutes. The same 5-minute wash was repeated once more (5 min × 2). Thereafter, the GaN substrate was taken out and dried in an isopropyl alcohol vapor dryer (82˚C).

*B2. Acid wash*: The GaN substrate was immersed 5 minutes in a room-temperature 1% HF + 7% $H_2O_2$ aqueous solution of pH = 2 to 3, contained in a Teflon® (polytetrafluoroethylene) vessel. The same wash was repeated two times (5 min × 2 cycles). The substrate was then overflow-rinsed in ultrapure water.

*B3. Alkali wash:* The GaN crystal substrate was immersed in an $NH_4OH$ aqueous solution heated to 45˚C and adjusted to pH = 11 to 12, was indirectly sonicated with ultrasound waves at a frequency of 990 kHz, and, with the washing solution being passed through a recirculating filter, was washed 3 minutes. The GaN substrate was then overflow-rinsed in ultrapure water.

*B4. Organic wash*: Same as the initial organic wash. The beaker containing isopropyl alcohol was put into a 50˚C water bath, and the GaN substrate was put into the washing solution and two cycles of the 5-minute wash were carried out. Thereafter, the GaN substrate was taken out and dried at 82˚C in the isopropyl alcohol vapor dryer.

Experimental Example 5 - Wet etching is organic-solvent washing + 2-stage acid wash + alkali wash

Dry etching and wet washing were combined to process a GaN substrate (50 mm ϕ, and 400 μm thickness). The wet washing was a combination of an organic wash, a two-stage acid wash, and an alkali wash. For the acid washes, in addition to the wash with HF + $H_2O_2$, an acid wash with sulfuric acid ($H_2SO_4$) was added. In the addition of the sulfuric acid wash, this example differs from Experimental Example 4. Adding the sulfuric acid wash was because it was surmised that utilizing an acid having strong oxidizing power should enable clinging metallic matter to be removed more cleanly.

Thereafter, the substrate was alkali-washed in an aqueous ammonium hydroxide ($NH_4OH$) solution. Since the process cannot finish with an alkali wash, the organic wash was done a second time at the end.

A. Dry etching

The dry etching conditions were the same as those of Experimental Example 1 (Table III).

The GaN substrate was housed into the etching chamber, which had been drawn down in advance to a pressure of $10^{-4}$ Pa; chlorine ($Cl_2$) gas as an etchant gas was introduced into the etching chamber interior, the interior pressure of which was put to 0.2 Pa, and high RF power was applied to the upper and lower electrodes to generate a plasma and dry etch the GaN substrate surface.

B. Wet washing - organic wash, 2-stage acid wash, and alkali wash

The wet washing was a process in which an acid wash ($H_2SO_4$) with sulfuric acid was added to Experimental Example 4. The conditions for the organic wash and the alkali wash were the same as those of Experimental Example 4.

*B1. Organic wash:* A quartz beaker containing isopropyl alcohol was put into a water bath heated to 50˚C, and the GaN substrate was soaked in the isopropyl alcohol and washed 5 minutes. The same 5-minute wash was repeated once more (5 min × 2). Thereafter, the GaN substrate was taken out and dried in an isopropyl alcohol vapor dryer (82˚C).

*B2. Stage 1 acid wash*: The GaN substrate was immersed 5 minutes in a room-temperature 1% HF + 7% $H_2O_2$ aqueous solution of pH = 2 to 3, contained in a Teflon® (polytetrafluoroethylene) vessel. The same wash was repeated two times (5 min × 2 cycles). The substrate was then overflow-rinsed in ultrapure water.

*B3. Stage 2 acid wash:* In a 4 : 1 (relative volume) sulfuric acid ($H_2SO_4$) : hydrogen peroxide ($H_2O_2$) aqueous solution (pH = 2 to 3) heated to 90˚C, the GaN substrate was immersed 30 minutes while the solution was circulated through a filter.

*B3. Alkali wash:* The GaN crystal substrate was immersed in an $NH_4OH$ aqueous solution heated to 45˚C and adjusted to pH = 11 to 12, was indirectly sonicated with ultrasound waves at a frequency of 990 kHz, and, with the washing solution being passed through a recirculating filter, was washed 3 minutes. The GaN substrate was then overflow-rinsed in ultrapure water.

*B4. Organic wash:* The beaker containing isopropyl alcohol was put into a 50˚C water bath, and the GaN substrate was put into the washing solution and two cycles of the 5-minute wash were carried out. Thereafter, the GaN substrate was taken out and dried at 82˚C in the isopropyl alcohol vapor dryer.

Table IV

| Exp. Ex. 1 | Exp. Ex. 2 | Exp. Ex. 3 | Exp. Ex. 4 | Exp. Ex. 5 |
|---|---|---|---|---|
| Dry etch | Dry etch | Dry etch | Dry etch | Dry etch |
| Organic wash | Organic wash | Organic wash | Organic wash | Organic wash |
| | KOH wash | dHF wash | HF + $H_2O_2$ | HF + $H_2O_2$ |
| | Organic wash | KOH wash | $NH_4OH$ | $H_2SO_4$ + $H_2O_2$ |
| | | Organic wash | Organic wash | $NH_4OH$ |
| | | | | Organic wash |

Evaluation of the Etching & Washing Techniques

In respect of the foregoing experimental examples differing in experimental conditions, residual metal and particle count on the surface of the wafers were evaluated. Total reflection X-ray fluorescence spectrometry (TXRF) was used to assay the type and quantity of metal clinging to the wafer surface. This is a technique according to which the sample surface is bombarded with polychromatic x-rays (x-rays including various continuous wavelengths) at a slight angle of inclination with the surface, whereby the rays are totally reflected; fluorescent x-rays that then travel upward from the surface are analyzed to find the type and quantity of atoms that are on the surface.

X-rays whose angle of inclination with respect to the surface is 5 milliradians (0.28 degrees) or less (i.e., whose incident angle is 89.78 degrees or more) are totally reflected without entering the sample. The X-ray beam includes rays of various wavelengths; the x-rays interact with impurities on the wafer surface, causing inner-shell electrons to leap out, and the resultant electron transition in order to fill the shells leads to the emission of fluorescent x-rays. The beam strikes the surface, and because a beam of lower energy than the incident beam is emitted, it is termed "fluorescent." Since the emitted beam is a collection of x-rays characteristic of the impurities, the fluorescent x-rays are split and quantitated to learn the type and quantity of atoms present on the surface. Because the beam is made incident almost parallel to the sample surface, the fluorescent x-rays from the atoms in the sample parent substance are scarce, wherein characteristic x-rays issue from the atoms forming the impurity particles that are on the surface. The rays are therefore totally reflected. Characteristic x-rays are the x-rays that are fluoresced due to outer-shell electrons falling from their orbitals when electrons in the inner shells of the atoms that x-rays excite are knocked out. Characteristic x-rays naturally are of wavelengths longer than the original x-rays, while their energy is the energy of the difference between two electron orbitals. This information is unique to every elemental atom and is previously known. The characteristic x-ray spectra are found in advance. If the sum of overlapping the known characteristic x-ray spectra for various given metals is able to yield the assayed fluorescent x-ray spectra, then that sum will give the type and density of the surface-residual metal.

The fact that the rays are reflected totally at the surface effectively shields out signals from the parent substance, which makes it possible to obtain information exclusively from atoms present in the surface. Another advantage to this spectrometric technique is that it is nondestructive—the atoms of interest on the surface can be detected even in trace quantities.

Herein, an x-ray source (wavelength = 0.1 nm to 1 nm) employing a tungsten tube was utilized to irradiate the sample surfaces at an inclination angle of 0.05˚. Apart from determining by TXRF the quantity of metal present on the surface, particles clinging to the surface were counted under microscopic observation. Since the wafers are for device fabrication, it is important that in addition to residual metal being minimal, the number of particles also be minimal.

Table V presents the results of the TXRF assay. The metals present in the sample surfaces were Si, Cr, Mn, Fe, Ni, Cu, Zn and Al.

Table V Metal Quantity ($10^{10}$ atoms/cm$^2$) and Particle Count (particles/cm2) on Post-Wet Etching, Dry Etching GaN Substrate Surface

| | Exp. Ex. 1 | Exp. Ex. 2 | Exp. Ex. 3 | Exp. Ex. 4 | Exp. Ex. 5 |
|---|---|---|---|---|---|
| Si | 2275.0 | 2174.0 | 174.0 | 58.0 | |
| Cr | 3.7 | 1.5 | | 0.8 | 1.3 |

(continued)

| | Exp. Ex. 1 | Exp. Ex. 2 | Exp. Ex. 3 | Exp. Ex. 4 | Exp. Ex. 5 |
|---|---|---|---|---|---|
| Mn | 0.6 | 1.2 | 0.5 | | 0.4 |
| Fe | 154.0 | 47.5 | 6.7 | 6.5 | 3.2 |
| Ni | 67.9 | 22.5 | 1.1 | 0.3 | 2.1 |
| Cu | 47.9 | 11.0 | 5.6 | 9.8 | 5.1 |
| Zn | 9.6 | 21.2 | 30.2 | 3.7 | 2.7 |
| Al | 267.0 | | | | |
| Particle count | 1225.0 | 103.0 | 85.0 | 21.0 | 24.0 |

Metal impurities remain behind on the wafer surface after being dry etched, which means that a clean surface cannot be obtained by the dry etching process alone.

Why Fe, Cr and Ni appear is that the chamber for the dry etch is made of stainless steel, and the chamber walls are eroded by the dry etching process. In powder form, the metals scatter about. A portion of that Fe, Cr and Ni would be what sticks to the surface of the GaN substrates. Aluminum is used in part of the chamber, and thus the aluminum would be dry-etched by the chlorine, with a portion of that contaminating the surface of the wafers. Therefore, the Fe, Cr, Ni and Al are atoms that come off from the chamber walls.

The copper (Cu) would seem to enter into the picture not from the chamber, but during polishing. The GaN wafers are polished using a device in which diamond grit is embedded into a copper platen. It is assumed that since copper atoms thus are in contact with the wafer surface during the polishing process, the copper atoms cling to the surface at that time. The reason why zinc (Zn) sticks to the surface of the GaN substrates is not understood.

Following the processes of Experimental Examples 1 through 5 metal elements were, as indicated in Table V, present in the sample surfaces; but since the starting GaN substrates were not identical, it does not necessarily follow that in the examples in which the amount of residual elements was less, the metal removal effectiveness by wet etching was greater, yet from the Table V results the effectiveness in broad terms can be understood.

Experimental Example 1 was a combination of dry etching and wet etching, with the wet etching being only an organic wash using isopropyl alcohol. In this case, $2 \times 10^{13}$ atoms/cm$^2$ Si was present, as was $1 \times 10^{12}$ atoms/cm$^2$ iron. There was also some $2 \times 10^{12}$ atoms/cm$^2$ of aluminum. And the particle count, at 1000 particles/cm$^2$, was of considerable volume.

Experimental Example 2 employed isopropyl alcohol and aqueous ammonium hydroxide (KOH) solution, which is strongly alkaline, for the wet etching. The KOH concentration was determined by a pH value of 11 to 12. It would appear that the concentration may be higher (the pH greater) than that. The particle count would thereby be approximately 100 particles/cm$^2$, a reduction to 1/10 that of Experimental Example 1. Alkaline solutions were understood to be effective in reducing particles; moreover, the solutions diminish aluminum to the level at which it is undetectable (under the detection threshold). It is evident that the KOH wash is extremely effective for removing aluminum.

In addition, iron, Ni and Cu also appear to be decreased by the alkali wash. The iron and Ni likely come scattered from the chamber walls and stick to the substrates; and with the principal components of the chamber being iron and Ni, the surface-adhering quantity of these metals is large, such that reducing the adherence of iron and Ni is of paramount importance. Nevertheless, in this example, the Si quantity was some $2 \times 10^{13}$ atoms/cm$^2$, about the same as that of Experimental Example 1, from which it would seem that Si really cannot be reduced by the KOH wash. Thus, the necessity of reducing Si, Fe and Ni further. These results indicate that only washing with organic solvent and strongly alkaline KOH is insufficient.

Experimental Example 3 further added for the wet etching a hydrogen fluoride (dHF) wash. The hydrogen fluoride concentration was defined by a pH value of 2 to 3, which is a fairly high acidic concentration. This led to the residual concentration of Si being greatly reduced. The concentration fell to about 1/10 of that of Experimental Examples 1 and 2, which is a striking result. Ni and Fe also decreased significantly, while aluminum was under the detection threshold. Although particles also decreased, the count did not drop markedly over that of Experimental Example 2. Further, Cr dropped to under the detection threshold, and although Mn did not vary much in Experimental Examples 1, 2 and 3, this was not a problem since there was only a trace amount to begin with. And while Zn increased successively in Experimental Examples 1, 2 and 3, this seems to be because neither acidic nor alkaline solutions are very effective.

Experimental Example 4 for the wet etching added hydrogen peroxide ($H_2O_2$) to hydrogen fluoride (HF) to heighten the oxidizing power. Furthermore, as the alkaline solution, instead of KOH $NH_4OH$ was employed, which was all the more effective in removing Si. Compared with Experimental Example 3, Si fell to about 1/3. If the residual quantity of metal elements, including metalloid Si, is $100 \times 10^{10}$ atoms (at)/cm$^2$ or less, the wafer is sufficiently clean to be useable as a device substrate. Effectiveness is also evident in that Zn decreased by comparison to Experimental Examples 2 and 3. Aluminum was under the detection threshold, and by comparison to Experimental Examples 2 and 3 the particle count fell.

In Experimental Example 5, in addition to the hydrogen fluoride and hydrogen peroxide ($H_2O_2$), a wash with sulfuric acid ($H_2SO_4$) + $H_2O_2$ was carried out. Sulfuric acid is by nature an acid of strong oxidizing power; yet with hydrogen peroxide, the oxidizing power is reinforced, which was presumed should be particularly beneficial for the removal of metal components. This wash decreased Si to under the detection threshold, while Fe, Cu, Zn, etc. were at levels where they could be said to have diminished slightly. Since the starting samples are not identical, the washing effectiveness cannot be judged straight away simply by comparing the numbers as such.

Photoluminescence Assay

With respect to the characteristics of a GaN substrate for fabricating light-emitting devices, it should be that by depositing epilayers of InGaN, GaN, or the like onto the substrate to form a *p-n* junction and attaching electrodes, an LED or LED would be fabricated and its light-emitting characteristics investigated. However, this requires device manufacturing facilities, and since such facilities are not available to the present inventors, this was not something that they could do simply.

Given the circumstances, then, a GaN layer was deposited to a 2 $\mu$m layer thickness onto the undoped GaN substrates, and onto that a 0.2 $\mu$m layer of InGaN was deposited, and the photoluminescence of the InGaN layer was examined.

Light from a He - Cd laser generating a 325-nm ultraviolet beam was directed onto the samples, and the intensity of the light (photoluminescence) emerging from the samples was detected with a photomultiplier. The luminous energy in its entirety was measured without splitting the light. Because the samples were illuminated with the 325-nm ultraviolet beam, which possesses energy greater than the bandgap, InGaN electrons in the valence band were excited into the conduction band, and the excited electrons on returning to the conduction band emitted light. This is the photoluminescence, and is utilized in instances such as to investigate the characteristics of film properties, since electron-hole pairs can be created and light emitted even without a *p-n* junction having been formed.

If the InGaN film is of low dislocation density and ideal crystallinity, the impurity level will be mininial and the non-light-emitting transitions will be few; thus the photoluminescence intensity will be strong. That the InGaN formed atop it is low dislocation density, high-quality crystal signifies that the surface of the GaN substrate that is the film's base, being smooth and without metal contamination, is favorable, which means that the base itself is serviceable. Of course, depending on the type of contaminant metal, there ought to be a difference in the influence that is exerted on epitaxially grown layers, but the nature of that difference is not understood. The amount of metal contamination and the photoluminescence alone were investigated, and the relationship between them found.

Therefore, the quality of the substrate surface can be evaluated according to the photoluminescence of the film. Although it is indirect the assay can be used to evaluate the quality of the substrate surface. This is different from an evaluation in which an LD or LED having a *p-n* junction is fabricated onto a substrate; but because the assay is useful for the simple and convenient evaluation of substrates, and can be carried out easily, it was utilized herein.

The results are presented in Table VI and in the figure. The horizontal axis in the figure is the metal atom density ($\times 10^{10}$ atoms/cm$^2$) on the GaN substrate surface, while the vertical axis is the photoluminescent output power in arbitrary scale graduations. If the photoluminescence was 3000 or more, then that sample was usable as a light-emitting device substrate. That photoluminescence is at a metal atom density level of $100 \times 10^{10}$ atoms/cm$^2$ (=$10^{12}$ atoms/cm$^2$), which is the critical contaminant-metal density. The present invention provides substrates rendered so that the metal contamination density is $10^{12}$ atoms/cm$^2$ or less, ($\leq 10^{12}$ atoms/cm$^2$).

What is even better is a density of $50 \times 10^{10}$ atoms/cm$^2$ or less, at which the photoluminescence is 4000 or more.

Table VI Photoluminescent Output for Each Experimental Example

|  | Photoluminescent output (arbitrary units) |
|---|---|
| Experimental Example 1 | 1250 |
| Experimental Example 2 | 1420 |
| Experimental Example 3 | 2350 |
| Experimental Example 4 | 3330 |
| Experimental Example 5 | 5800 |

To take a look at this data compared with the experimental-example residual metal density mentioned earlier, data in which the densities of all the metals (Si, Cr, Mn, Fe, Ni, Cu, Zn, Al) at the surface has been summed is as follows.

$$\text{Experimental Example } 1 = 2825 \times 10^{10} \text{ atoms/cm}^2,$$

$$\text{Experimental Example } 2 = 2279 \times 10^{10} \text{ atoms/cm}^2,$$

$$\text{Experimental Example } 3 = 218 \times 10^{10} \text{ atoms/cm}^2,$$

$$\text{Experimental Example } 4 = 79 \times 10^{10} \text{ atoms/cm}^2,$$

and

$$\text{Experimental Example } 5 = 15 \times 10^{10} \text{ atoms/cm}^2,$$

which being the case, Experimental Examples 4 and 5 suit the condition that the metal atom count be $100 \times 10^{10}$ atoms/cm$^2$ or less. Experimental Example 4 was with HF + H$_2$O$_2$, while Experimental Example 5 utilized HF + H$_2$O$_2$ and H$_2$SO$_4$ + H$_2$O$_2$.

As described previously, these solutions were selected according to conditions that they have no selectivity, have etching ability, and have an oxidation-reduction potential of 1.2 V or more; these are the conditions under which the solutions excel in acting to remove residual metal effectively to clean the wafer surface.

Industrial Applicability

According to the present invention, the process-transformed layer resulting from polishing GaN is removed to enable wafers with smooth, flat surfaces to be obtained; and GaN wafers having ideal surfaces on which superficially clinging residual metal is virtually non-existent can be made available. Light-emitting devices produced utilizing wafers of the present invention exhibit high light-emitting efficiency.

**Claims**

1. A gallium-nitride semiconductor substrate, **characterized in that** metal contamination on the substrate surface is $10 \times 10^{11}$ atoms/cm$^2$ or less.

2. A gallium-nitride semiconductor substrate, **characterized in that** metal contamination on the substrate surface is $5 \times 10^{11}$ atoms/cm$^2$ or less.

3. A method of manufacturing a gallium-nitride semiconductor substrate, **characterized in that** in order to remove a process-transformed layer resulting from polishing, dry etching using a halogen plasma is carried out; and wet etching by means of an etchant having no Ga-face and N-face selectivity, having etching ability, and having an oxidation-reduction potential of 1.2 V or more is carried out; whereby contaminant metal produced by the dry etching is removed.

4. A method of manufacturing a gallium-nitride semiconductor substrate, **characterized in that** wet etching by means of an etchant that is one of HF + H$_2$O$_2$, HCl + H$_2$O$_2$, H$_2$SO$_4$ + H$_2$O$_2$, HNO$_3$ + H$_2$O$_2$, HF + O$_3$, HCl + O$_3$, H$_2$SO$_4$ + O$_3$, HNO$_3$, or HNO$_3$ + O$_3$, and that has an oxidation-reduction potential of 1.2 V or more is carried out.

5. A method of manufacturing a gallium–nitride semiconductor substrate as set forth in claim 3 or 4, **characterized in that** a wash for taking off organic matter by means of an organic solvent, and a wash by means of an alkaline solution in order to take off nonmetal contaminants are carried out either before or after the wet etching.

FIGURE

## INTERNATIONAL SEARCH REPORT

| International application No. |
|---|
| PCT/JP2004/011683 |

**A. CLASSIFICATION OF SUBJECT MATTER**
Int.Cl$^7$ H01L21/306, H01L21/3065

According to International Patent Classification (IPC) or to both national classification and IPC

**B. FIELDS SEARCHED**

Minimum documentation searched (classification system followed by classification symbols)
Int.Cl$^7$ H01L21/306, H01L21/3065

Documentation searched other than minimum documentation to the extent that such documents are included in the fields searched
| | | | |
|---|---|---|---|
| Jitsuyo Shinan Koho | 1922–1996 | Toroku Jitsuyo Shinan Koho | 1994–2004 |
| Kokai Jitsuyo Shinan Koho | 1971–2004 | Jitsuyo Shinan Toroku Koho | 1996–2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 8-316187 A (Kurita Water Industries Ltd.), 29 November, 1996 (29.11.96), Par. Nos. [0001], [0005] to [0006] & US 5814157 A & KR 225996 B | 1-5 |
| Y | JP 10-233382 A (Hewlett-Packard Co.), 02 September, 1998 (02.09.98), Par. Nos. [0012] to [0013] & US 5919715 A & EP 860865 A1 | 1-5 |
| Y | JP 2001-244240 A (Speed Fam Kabushiki Kaisha), 07 September, 2001 (07.09.01), Par. Nos. [0001], [0008] & US 2001-18271 A1 | 3,5 |

☒ Further documents are listed in the continuation of Box C.   ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 09 November, 2004 (09.11.04) | 14 December, 2004 (14.12.04) |

| Name and mailing address of the ISA/ | Authorized officer |
|---|---|
| Japanese Patent Office | |
| Facsimile No. | Telephone No. |

Form PCT/ISA/210 (second sheet) (January 2004)

## INTERNATIONAL SEARCH REPORT

| | International application No. |
|---|---|
| | PCT/JP2004/011683 |

C (Continuation).  DOCUMENTS CONSIDERED TO BE RELEVANT

| Category* | Citation of document, with indication, where appropriate, of the relevant passages | Relevant to claim No. |
|---|---|---|
| Y | JP 2003-218085 A  (Wacker NSCE Kabushiki Kaisha), 31 July, 2003 (31.07.03), Par. Nos. [0002] to [0003], [0012] (Family: none) | 4 |
| Y | JP 2002-43270 A  (Matsushita Electric Industrial Co., Ltd.), 08 February, 2002 (08.02.02), Par. Nos. [0020] to [0023] (Family: none) | 5 |

Form PCT/ISA/210 (continuation of second sheet) (January 2004)